# EUROPEAN PATENT SPECIFICATION

(11) **EP 0 761 599 B1**
(45) Date of publication and mention of the grant of the patent: **29.10.2003**
(21) Application number: 96113770.0
(22) Date of filing: 28.08.1996
(51) Int. Cl.: C01D 1/28, C23F 1/32, H01L 21/302, C01D 1/32

(54) **Method of purifying alkaline solution and method of etching semiconductor wafers**
Verfahren zum Reinigen einer alkalischen Lösung und Methode zum Ätzen von Halbleiterscheiben
Méthode de purification d'une solution alcaline et méthode de décapage de tranches de semi-conducteurs

(30) Priority: 29.08.1995 JP 22035095; 20.08.1996 JP 21850396
(43) Date of publication of application: 12.03.1997
(73) Proprietor: SHIN-ETSU HANDOTAI COMPANY LIMITED, Chiyoda-ku Tokyo (JP)
(72) Inventor: Nakano, Masami, Vancouver, WA (US); Uchiyama, Isao, Nishishirakawa-gun, Fukushima-ken (JP); Ajito, Toshio, Nishishirakawa-ku, Fukushima-ken (JP); Kudo, Hideo, Nishishirakawa-ku, Fukushima-ken (JP)
(74) Representative: Grünecker, Kinkeldey, Stockmair & Schwanhäusser Anwaltssozietät

(56) References cited:
- PATENT ABSTRACTS OF JAPAN vol. 004, no. 117 (E-022), 20 August 1980 & JP 55 074142 A (FUJI ELECTRIC CO LTD), 4 June 1980
- PATENT ABSTRACTS OF JAPAN vol. 015, no. 238 (C-0841), 19 June 1991 & JP 03 075216 A (KANTO CHEM CO INC), 29 March 1991
- PATENT ABSTRACTS OF JAPAN vol. 004, no. 081 (C-014), 11 June 1980 & JP 55 047221 A (TSURUMI SODA KK), 3 April 1980
- PATENT ABSTRACTS OF JAPAN vol. 002, no. 052 (C-011), 14 April 1978 & JP 53 009295 A (NIPPON SODA CO LTD), 27 January 1978

## Description

The present invention relates to a method of purifying an alkaline solution by converting metal ions contained in said solution into metal. The present invention further relates to a method of etching semiconductor wafers which enables to etch them without deteriorating the quality thereof with an alkaline solution purified by said purifying method.

Generally, the manufacturing method of semiconductor wafers includes a slicing step to obtain wafers of thin disc shape by slicing a single crystal ingot formed by a pulling step using a crystal pulling machine; a chamfering step to chamfer a peripheral edge portion of the wafer obtained through the slicing step to prevent cracking or breakage of the wafer; a lapping step to flatten the surface of the chamfered wafer by lapping it; an etching step to remove processing damage of the so chamfered and lapped wafer; a polishing process to polish the surface of the etched wafer; and a cleaning step for cleaning the polished wafer to remove the polishing agent or dust particles from its surface.

As the etching step, there are two types of steps, that is, an acid etching step using an acid etching solution of a mixed acid or the like and an alkaline etching step using an alkaline etching solution of NaOH or the like. In the acid etching step, the etching speed is fast and hence it is difficult to uniformly etch the wafer with a problem that flatness of the wafer is deteriorated. Therefore, recently an alkaline etching which uses a sodium hydroxide solution, a potassium hydroxide solution, and an alkyl ammonium hydroxide solution, etc. is predominantly employed because the alkaline etching does not deteriorate flatness of the wafer due to its uniform etching even if its etching speed is slow.

In the alkaline etching of the semiconductor wafer, an industrial alkaline solution on the market of high metallic impurity concentration is used as it is. It is needless to say that a lot of metallic impurities are included in the alkaline solution of the industrial grade generally used. Even an alkaline solution of the electronic industrial grade used for etching of the semiconductor wafer presently contains metallic impurities of several tens of ppb to several ppm.

There are nickel, chromium, iron and copper as metallic impurities included in this alkaline solution. A lot of nickel, chromium and iron, which are raw materials of stainless steels used in the manufacturing process of the alkaline solution, are especially included.

Conventionally, it has been supposed that these metallic impurities contaminate only the surface of the semiconductor wafer when the wafer was etched by using an alkaline solution which contained these metallic impurities. Therefore, it is considered that metallic impurities, which adhere to the surface of the wafer, are removed enough by after cleaning the wafer with an acid solution. Accordingly, it was common sense of those skilled in the art that the existence of metallic impurities in the alkaline etching solution does not affect especially to the wafer quality.

The present inventors keep researching the alkaline etching process during many years. According to a recent outcome of the present inventor's researches, in contradiction to the common sense of those skilled in the art, it was revealed the surprising fact that metal ions of a part of metallic impurities such as copper and nickel which exist in the alkaline etching solution diffuse into the deep inside of the wafer while etching with the result that the wafer quality is deteriorated and the characteristic of the semiconductor device made of the wafer is remarkably degraded.

There may be an idea to use the alkaline solution of high purity as measures to prevent deterioration in the wafer quality due to the alkaline etching solution. However, an alkaline solution of high purity on the market is only an extremely expensive alkaline solution of the analysis grade. It does not match at all in the cost to employ an alkaline solution for an analytical use as an industrial use.

JP-A-55-74142 discloses a method of refining a semiconductor etching alkaline liquid wherein the etching alkaline liquid is passed and filtered through a powdered layer of highly pure semiconductor material such as silicon powder so that harmful impurities such as heavy metals and iron react with the powder or are adsorbed on the powder surface to be removed from the alkaline liquid.

The inventors found by extended researches that metal ions in an alkaline solution may be converted into metal by an easy technique and further semiconductor wafers etched with the alkaline solution in which metal ions were converted into metal are not deteriorated even in the physical existence of the metallic impurities. The present invention was accomplished on the basis of the surprising finding.

It is an object of the present invention to provide a novel method of purifying an alkaline solution which enables metallic impurities, especially metal ions in the alkaline solution to be converted into metal at a low-cost and extremely efficiently as well as a new method of etching semiconductor wafers which enables to etch the wafers without deteriorating the quality thereof by using the purified alkaline solution.

The present invention provides a method of purifying an alkaline solution containing metal ions, said method comprising the steps of (a) dissolving metallic silicon in said alkaline solution, and (b) converting said metal ions contained in said alkaline solution, with reaction products generated when the metallic silicon is dissolved in said alkaline solution, into metal, wherein said metal remains physically in said alkaline solution in the form of a solid impurity.

As the above-mentioned metallic silicon, there can be enumerated polysilicon and single crystal silicon. These can be used by mixing them or alone. For the metallic silicon, it is preferable to use products of as high purity as possible within the range commercially practicable.

There is no special limitation for the dissolution amount of the above-mentioned metallic silicon as long as the effect of this invention is achieved, but 0.2 g/liter or more is suitable therefor. When the dissolution amount is too small, the achievement of the effect of this invention is not enough. When this dissolution amount is too large, it is disadvantageous from an economical viewpoint.

The present invention further provides a method of purifying an alkaline solution containing metal ions, said method comprising the steps of (a) dissolving hydrogen gas in said alkaline solution, and (b) converting said metal ions contained in said alkaline solution, with said hydrogen gas dissolved in said alkaline solution, into metal.

Moreover, the present invention provides a method of etching semiconductor wafers, said method comprising the steps of (a) purifying an alkaline solution according to a purifying method as defined above, and (b) etching the semiconductor wafers by using the purified alkaline solution.

Preferred embodiments of the present invention are set forth in the sub-claims.

In this invention, there are nickel ions, copper ions, chromium ions, iron ions, etc, as impurity metal ions to be converted into metal. Among these ions, it is important from a viewpoint of the semiconductor wafer quality to convert the nickel ions and the copper ions with a large diffusion speed in silicon single crystal into metal.

The metal ion concentration in an alkaline solution used in etching semiconductor wafers according to the present invention may be suitably limited to 50 ppb or less, preferably 20 ppb or less, more preferably 10 ppb or less. With these concentration limitations, the achievement of the effect of this invention is more enough.

The purification of the alkaline solution of this invention connotes that impurity metal ions in the alkaline solution are converted into metal. Even if solid impurity metals exist physically in the alkaline solution, unless they exist in the state of metal ions, the alkaline solution corresponds to the state of the purified alkaline solution according to this invention. That is, the quality deterioration of the semiconductor wafers due to the etching thereof does not occur even if solid impurity metals exist in an alkaline solution as long as they do not exist as impurity metal ions. On the contrary, when the solid impurity metals do not exist at all but exist as metal ions in the alkaline solution, if the semiconductor wafers are etched by using this alkaline solution, deterioration in the wafer quality thereof is caused.

The present invention is based on three inventive findings: the first finding that the existence of impurity metal ions in an alkaline solution greatly affects quality deterioration of semiconductor wafers due to alkaline etching; the second finding that conversion of the metal ions in the alkaline solution into metal can be carried out by a very easy technique; and the third finding that when semiconductor wafers are etched by using the purified alkaline solution quality deterioration thereof does not occur.

The above and other objects, features and advantages of the present invention will become manifest to those skilled in the art upon making reference to the detailed description and the accompanying sheets of drawings.

Fig. 1 is a graph showing the relation between an iron ion concentration and a nickel ion concentration in the sodium hydroxide solution and the elapsed time after adding polysilicon thereto in Example 1.

Fig. 2 is a graph showing the relation between an iron ion concentration and a nickel ion concentration in the sodium hydroxide solution and the elapsed time after adding single crystal silicon thereto in Example 2.

Fig. 3 is a graph showing the relation between the amount of dissolved polysilicon and a nickel ion concentration in the sodium hydroxide solution in Example 3.

Fig. 4 is a graph showing the relation between hydrogen gas blowing and an iron ion concentration and a nickel ion concentration in the sodium hydroxide solution in Example 4.

Fig. 5 is a graph showing a nickel concentration on a wafer which was etched by a sodium hydroxide solution purified with polysilicon in Example 5 and that on another wafer which was etched by an unpurified sodium hydroxide solution.

Fig. 6 is a graph showing a nickel concentration on a wafer which was etched by a sodium hydroxide solution purified with single crystal silicon in Example 6 and that on another wafer which was etched by an unpurified sodium hydroxide solution.

Fig. 7 is a graph showing the relation between a nickel concentration on a wafer etched by a sodium hydroxide solution and a nickel ion concentration in the sodium hydroxide solution in Example 7.

Fig. 8 is a graph showing the relation between a copper concentration on a wafer etched by a sodium hydroxide solution and a copper ion concentration in the sodium hydroxide solution in Example 7.

Fig. 9 is a graph showing the relation between an iron concentration on a wafer etched by a sodium hydroxide solution and an iron ion concentration in the sodium hydroxide solution in Example 7.

The present invention will be described below in greater detail by way of the following examples which should be construed as illustrative rather than restrictive.

### Example 1

### (purification of a sodium hydroxide solution with polysilicon)

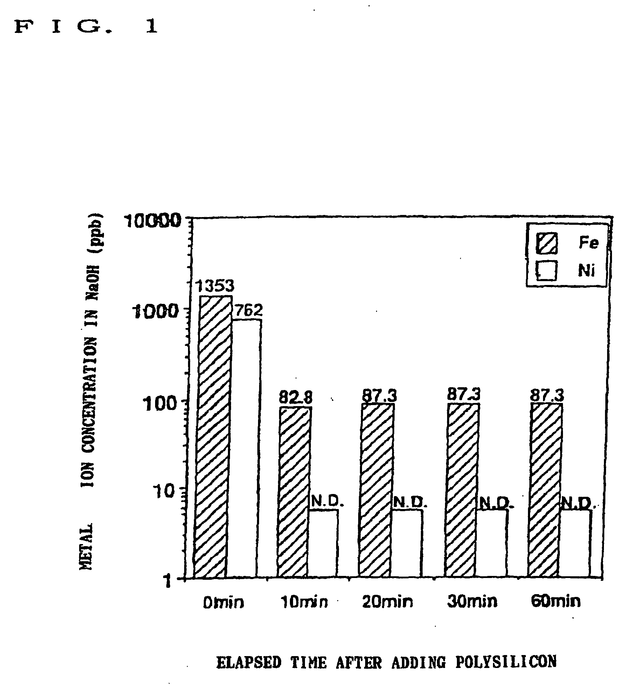

To a sodium hydroxide solution (45%, 20 liters and 80 °C), 200g of semiconductor grade granular polysilicon was added. Before and after adding the polysilicon 10 minutes later, 20 minutes later, 30 minutes later and 60 minutes later, 10 ml of the sodium hydroxide solution diluted to 45 times was sampled, respectively. Then an iron ion concentration and a nickel ion concentration thereof were analyzed by an ion-exchange chromatography. The results of the analyses are shown in Fig. 1. As is apparent from the results of Fig. 1, both the iron ion concentration and the nickel ion concentration were decreased and especially the latter was remarkably decreased or non-ionized. In Figs. 1-4, N.D. means that the measured data have been under detection limit.

### Example 2

### (purification of a sodium hydroxide solution with single crystal silicon)

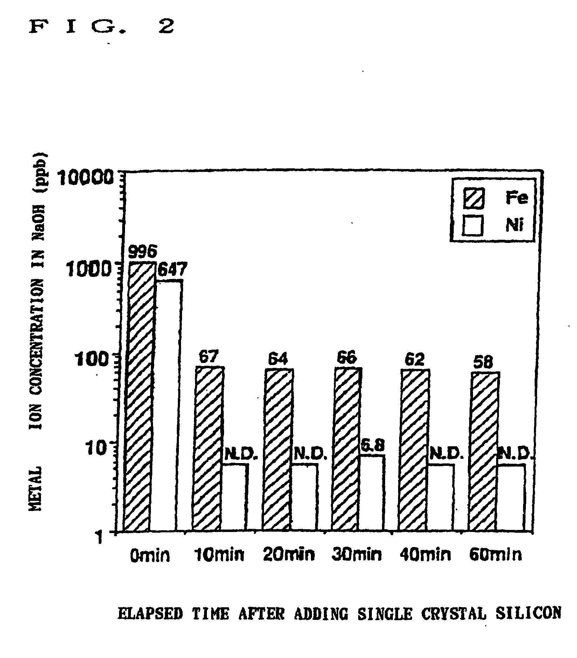

To a sodium hydroxide solution (45%, 20 liters and 80 °C), 10 sheets of single crystal silicon wafers having 200mm φ were added. Before and after adding the wafers 10 minutes later, 20 minutes later, 30 minutes later and 60 minutes later, 10 ml of the hydroxide sodium solution diluted to 45 times was sampled, respectively. Then an iron ion concentration and a nickel ion concentration thereof were analyzed by an ion-exchange chromatography. The results of the analyses are shown in Fig. 2. As is apparent from the results of Fig. 2, both the iron ion concentration and the nickel ion concentration were decreased and especially the latter was remarkably decreased or non-ionized.

### Example 3

### (purification of a sodium hydroxide solution with polysilicon)

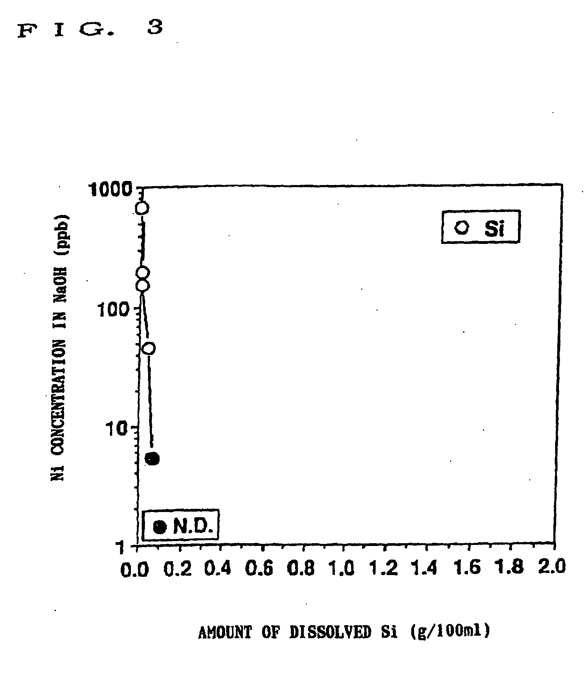

To a sodium hydroxide solution (45%, 20 liters and 80 °C), 200g of semiconductor grade granular polysilicon was added. Before and after adding the polysilicon 1 minute later, 10 ml of the sodium hydroxide solution diluted to 45 times was sampled, respectively, and the added polysilicon was removed from the solution. Then a nickel ion concentration thereof was analyzed by an ion-exchange chromatography. The collected polysilicon was weighed and the dissolution amount thereof was calculated. The same procedure as mentioned above was repeated after adding 3 minutes later, 5 minutes later and 10 minutes later, respectively. The results of the analyses are shown in Fig. 3. As is apparent from the results of Fig. 3, the amount of the nickel ions in the sodium hydroxide solution was decreased rapidly only by dissolving a small amount of polysilicon.

### Example 4

### (purification of a sodium hydroxide solution with hydrogen gas)

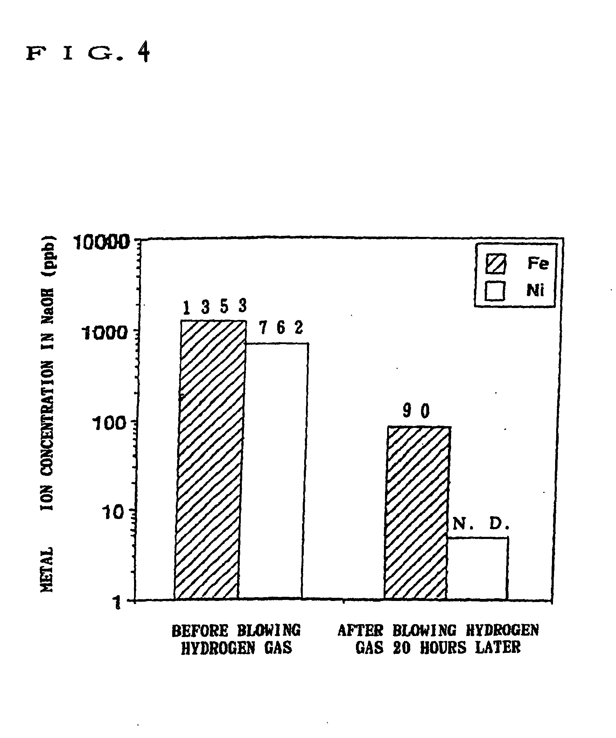

Into a sodium hydroxide solution (45%, 20 liters and 80 °C), hydrogen gas was blown at a rate of 0.5 liter/min. Before and after blowing the hydrogen gas 20 hours later, 10 ml of the sodium hydroxide solution diluted to 45 times was sampled, respectively, and then a nickel ion concentration and an iron ion concentration thereof were analyzed by an ion-exchange chromatography. The results of the analyses are shown in Fig. 4. As is apparent from the results of Fig. 4, both the iron ion concentration and the nickel ion concentration were decreased and especially the latter was excellently removed.

### Example 5

### (etching a wafer by a sodium hydroxide solution purified with polysilicon)

To a sodium hydroxide solution (45%, 20 liters and 80 °C), 200g of semiconductor grade granular polysilicon was added. After leaving the solution for one hour, a sample wafer was etched by using the solution and the contamination level of the wafer was examined. This experiment was conducted under the following condition.

### Experiment condition:

. Sample wafer; Czochralski-grown p-type, <100>-oriented, 0.005-0.010 Ωcm, 200mm-diameter, lapped silicon wafers
. Alkaline etching with a sodium hydroxide solution (45% aqueous solution containing dissolved polysilicon, 80 °C and 10 minutes)
. Cleaning with water (25 °C and 3 minutes)
. Cleaning with a solution of hydrochloric acid, hydrogen peroxide and water (80°C and 3 minutes)
. Cleaning with water (25 °C and 3 minutes)
. Drying with IPA vapor (81.5 °C and 1 minutes)
. Experiment tank (common in the above treatments)
   Size (mm); 280×280 ×300 H
   Capacity; 20 liters
   Material; Quart
. Composition of the solution of hydrochloric acid, hydrogen peroxide and water; Hydrochloric acid solution: Hydrogen peroxide water: Water = 1 : 1 : 10 (volume ratio) (Use a 36 weight percent hydrochloric acid solution and a 30 weight percent hydrogen peroxide water)

The wafer etched according to the above-mentioned condition was evaluated as follows. One side of the etched wafer was subjected to sand blasting and then thermal oxidation at 600°C. The thermal oxide film on the side of the wafer sand blasted was vapor phase decomposed with hydrofluoric acid vapor. The decomposed materials were collected by using a solution containing hydrofluoric acid. The collected materials were analyzed by ICP-MS (inductively coupled plasma mass spectrometer).

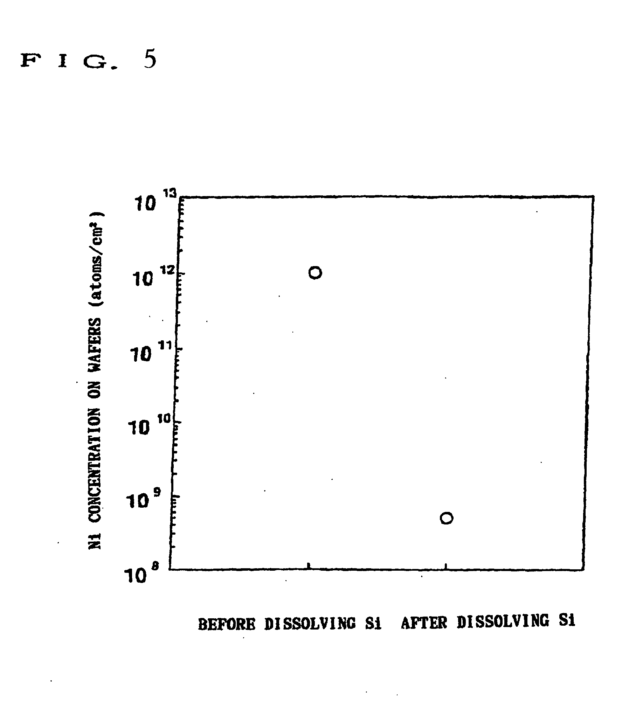

The result of the analysis is shown in Fig. 5 together with one obtained in the case that a sample wafer was etched with a sodium hydroxide solution without adding polysilicon. As is apparent from the results of Fig. 5, the nickel ion concentration on the wafer etched with the sodium hydroxide solution with adding polysilicon was remarkably decreased.

### Example 6

### (etching a wafer by a sodium hydroxide solution purified with single crystal silicon)

To a sodium hydroxide solution (45%, 20 liters and 80 °C), 200g of single crystal silicon (silicon wafer) was added. After leaving the solution for 60 minutes, a sample wafer was etched by using the solution under the condition same as Example 5 and the contamination level of the wafer was examined as Example 5.

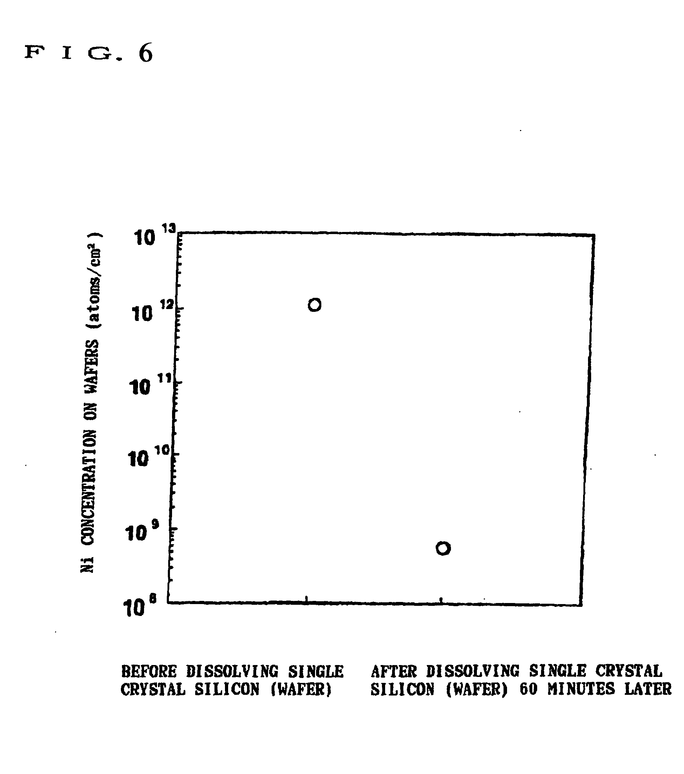

The result of the analysis is shown in Fig. 6 together with one obtained in the case that a sample wafer was etched with a sodium hydroxide solution without adding single crystal silicon (silicon wafer). As is apparent from the results of Fig. 6, the nickel ion concentration on the wafer etched with the sodium hydroxide solution with adding single crystal silicon (silicon wafer) was remarkably decreased.

### Example 7

### (the relation between Ni, Cu and Fe concentrations on an alkaline etched wafer and corresponding concentrations in a sodium hydroxide solution)

### Experiment condition:

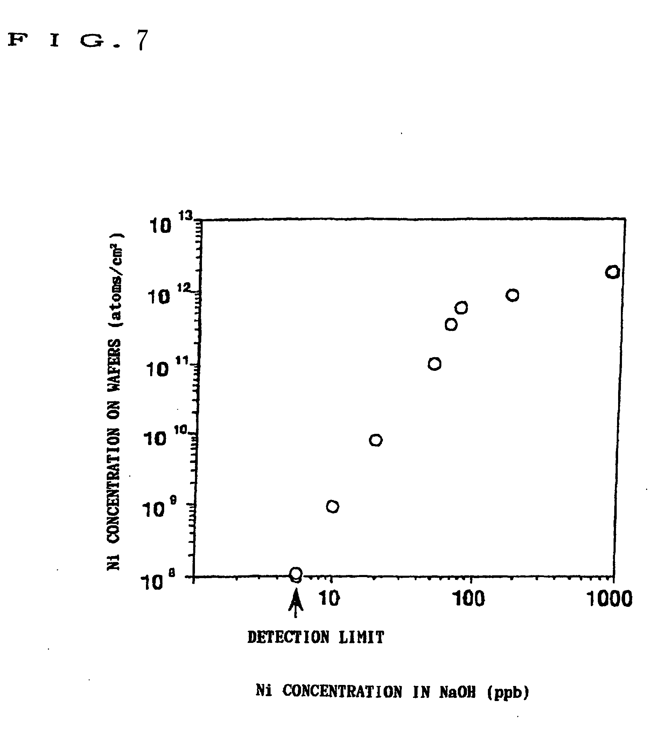

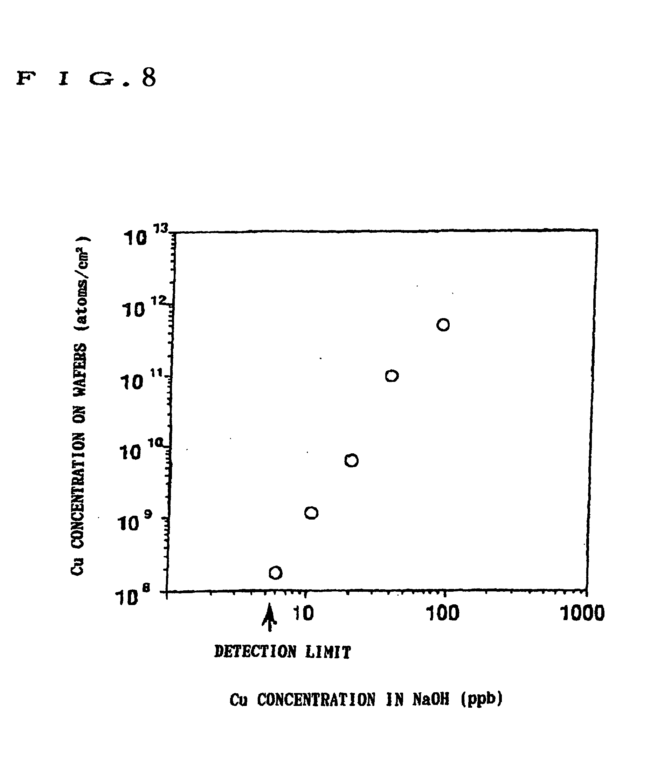

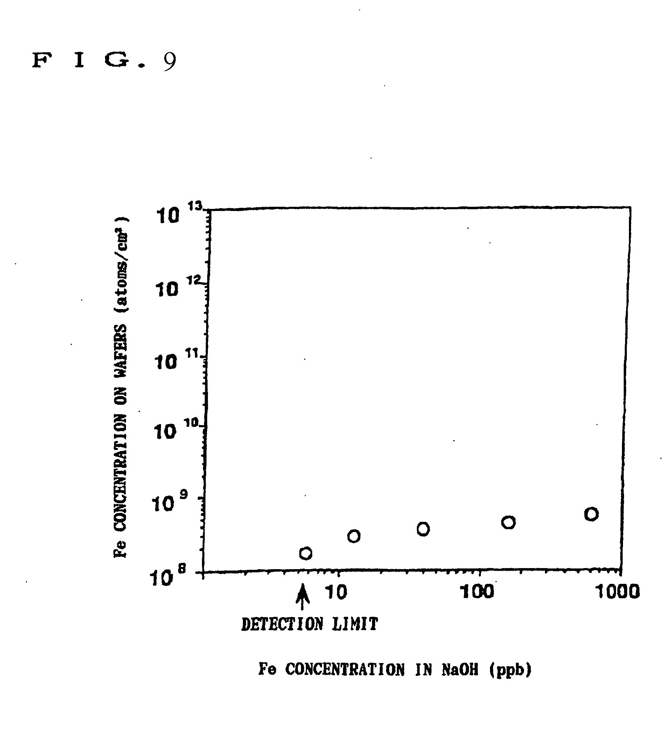

· Sample wafer; Czochralski-grown p-type, <100>-oriented, 0.005-0.010 Ωcm, 200mm-diameter, lapped silicon wafer
· Alkaline etching with a sodium hydroxide solution (45% aqueous solution, 80°C and 10 minutes)
· Cleaning with water (25 °C and 3 minutes)
· Cleaning with a solution of hydrochloric acid, hydrogen peroxide and water (80°C and 3 minutes)
· Cleaning with water (25 °C and 3 minutes)
· Drying with IPA vapor (81.5 °C and 1 minutes)
· Experiment tank (common in the above treatments)
   Size (mm); 280×280 ×300 H
   Capacity; 20 liters
   Material; Quart
· Composition of the solution of hydrochloric acid, hydrogen peroxide and water; Hydrochloric acid solution: Hydrogen peroxide water: Water = 1 : 1 : 10 (volume ratio) (Use a 36 weight percent hydrochloric acid solution and a 30 weight percent hydrogen peroxide water)
· Measurement of the metal impurity concentrations on the etched wafer; One side of the etched wafer was subjected to sand blasting and then thermal oxidation at 600°C. The thermal oxide film on the side of the wafer sand blasted was vapor phase decomposed with hydrofluoric acid vapor. The decomposed materials were collected by using a solution containing hydrofluoric acid. The collected materials were analyzed by ICP-MS (inductively coupled plasma mass spectrometer).
· Measurement of the metal ion concentrations in the sodium hydroxide solution; Before etching the wafer, 10 ml of the sodium hydroxide solution diluted to 45 times was sampled and then each ion concentration thereof was analyzed by an ion-exchange chromatography. The results of the analyses are shown in Fig. 7 (Ni concentration), Fig. 8 (Cu concentration) and Fig. 9 (Fe concentration). As is apparent from the results of Figs. 7-9, with the increase of the metal ion concentrations in the sodium hydroxide solution, the metal concentrations on the etched wafer were increased and especially Ni and Cu concentrations were remarkably increased.

Moreover, when the metal ion concentration in the sodium hydroxide solution becomes 10 ppb or less, it is confirmed that the metal on the wafer hardly exists, too. In addition, it is also confirmed that metallic contamination on the wafer does not become so much if the metal ion concentration in the sodium hydroxide solution is limited to 50 ppb or less. Further, it is confirmed that the metal ion concentration therein is preferably 20 ppb or less and more preferably 10 ppb or less.

As stated above, according to the method of purifying an alkaline solution of this invention, metal ions (nickel, iron, copper, etc.) in the alkaline solution can be remarkably decreased at a low-cost by an easy operation. Moreover, according to the method of etching semiconductor wafers of this invention wherein an alkaline solution containing a low metal ion concentration is used as an etching solution, the metallic contamination level due to the etching of the semiconductor wafers is greatly decreased, there being neither deterioration in the wafer quality nor deterioration in the characteristic of the semiconductor device.

Obviously, various minor changes and modifications of the present invention are possible in the light of the above teaching. It is therefore to be understood that within the scope of the appended claims the invention may be practiced otherwise than as specifically described.

## Claims

1. A method of purifying an alkaline solution containing metal ions, said method comprising the steps of:
(a) dissolving metallic silicon in said alkaline solution, and
(b) converting said metal ions contained in said alkaline solution, with reaction products generated when the metallic silicon is dissolved in said alkaline solution, into metal,
wherein said metal remains physically in said alkaline solution in the form of a solid impurity.

2. The method of claim 1, wherein said metallic silicon is polysilicon and/or single crystal silicon.

3. The method of claim 1 or 2, wherein the dissolution amount of said metallic silicon is 0.2 g/l or more.

4. A method of purifying an alkaline solution containing metal ions, said method comprising the steps of:
(a) dissolving hydrogen gas in said alkaline solution, and
(b) converting said metal ions contained in said alkaline solution, with said hydrogen gas dissolved in said alkaline solution, into metal.

5. The method of any of claims 1 to 4, wherein said alkaline solution is a sodium hydroxide solution or a potassium hydroxide solution.

6. The method of any of claims 1 to 5, wherein said metal ions are copper ions and/or nickel ions.

7. A method of etching semiconductor wafers, said method comprising the steps of:
(a) purifying an alkaline solution according to the method of any of claims 1 to 6, and
(b) etching the semiconductor wafers by using the purified alkaline solution.

## Patentansprüche

1. Verfahren zum Reinigen einer alkalischen Lösung, die Metallionen enthält, umfassend:
(a) das Auflösen von metallischem Silicium in der alkalischen Lösung und
(b) das Umwandeln der Metallionen, die in der alkalischen Lösung enthalten sind, mit Reaktionsprodukten, die beim Auflösen des metallischen Siliciums in der alkalischen Lösung gebildet wurden, in Metall,
wobei das Metall als solches in Form einer festen Verunreinigung in der alkalischen Lösung verbleibt.

2. Verfahren nach Anspruch 1, wobei das metallische Silicium polykristallines Silicium oder monokristallines Silicium ist oder ein Gemisch davon umfasst.

3. Verfahren nach Anspruch 1 oder 2, wobei die Menge an metallischem Silicium, das gelöst wird, 0,2 g/l oder mehr beträgt.

4. Verfahren zum Reinigen einer alkalischen Lösung, die Metallionen enthält, umfassend:
(a) das Auflösen von Wasserstoffgas in der alkalischen Lösung und
(b) das Umwandeln der Metallionen, die in der alkalischen Lösung enthalten sind, mit dem Wasserstoffgas, das in der alkalischen Lösung gelöst wurde, in Metall.

5. Verfahren nach einem der Ansprüche 1 bis 4, wobei die alkalische Lösung eine Natriumhydroxidlösung oder eine Kaliumhydroxidlösung ist.

6. Verfahren nach einem der Ansprüche 1 bis 5, wobei die Metallionen Kupferionen und/oder Nickelionen sind.

7. Verfahren zum Ätzen eines Halbleiterwafers, umfassend:
(a) das Reinigen einer alkalischen Lösung unter Anwendung des Verfahrens nach einem der Ansprüche 1 bis 6 und
(b) das Ätzen des Halbleiterwafers unter Verwendung der gereinigten alkalischen Lösung.

## Revendications

1. Procédé de purification d'une solution alcaline contenant des ions métalliques, ledit procédé comprenant les étapes de :
(a) dissolution de silicium métallique dans ladite solution alcaline, et
(b) conversion desdits ions métalliques contenus dans ladite solution alcaline, avec les produits réactionnels engendrés lorsque le silicium métallique est dissous dans ladite solution alcaline, en métal,
dans lequel ledit métal reste physiquement dans ladite solution alcaline sous la forme d'une impureté solide.

2. Procédé selon la revendication 1, dans laquelle ledit silicium métallique est du polysilicium et/ou du silicium monocristallin.

3. Procédé selon la revendication 1 ou 2, dans laquelle la quantité dissoute dudit silicium métallique est 0,2 g/l ou plus.

4. Procédé de purification d'une solution alcaline contenant des ions métalliques, ledit procédé comprenant les étapes de :
(a) dissolution d'hydrogène gazeux dans ladite solution alcaline, et
(b) conversion desdits ions métalliques contenus dans ladite solution alcaline, avec ledit hydrogène gazeux dissous dans ladite solution alcaline, en métal.

5. Procédé selon l'une quelconque des revendications 1 à 4, dans laquelle ladite solution alcaline est une solution d'hydroxyde de sodium ou une solution d'hydroxyde de potassium.

6. Procédé selon l'une quelconque des revendications 1 à 5, dans laquelle lesdits ions métalliques sont des ions de cuivre et/ou des ions de nickel.

7. Procédé de décapage de tranches de semi-conducteurs, ledit procédé comprenant les étapes de :
(a) purification d'une solution alcaline selon le procédé de l'une quelconque des revendications 1 à 6, et
(b) décapage des tranches de semi-conducteurs en utilisant la solution alcaline purifiée.
